# EUROPÄISCHE PATENTSCHRIFT

(11) **EP 3 243 215 B1**
(45) Veröffentlichungstag und Bekanntmachung des Hinweises auf die Patenterteilung: **27.11.2019**
(21) Anmeldenummer: 16700028.0
(22) Anmeldetag: 04.01.2016
(51) Int. Cl.: H01L 21/56, H01L 23/31, H05K 5/00

(54) **VERFAHREN ZUM HERSTELLEN EINES ELEKTRONIKMODULS INSBESONDERE EINES GETRIEBESTEUERMODULS**
METHOD FOR PRODUCING AN ELECTRONICS MODULE, IN PARTICULAR A TRANSMISSION CONTROL MODULE
PROCÉDÉ DE FABRICATION D'UN MODULE ÉLECTRONIQUE EN PARTICULIER D'UN MODULE DE COMMANDE DE TRANSMISSION

(30) Priorität: 09.01.2015 DE 102015200219
(43) Veröffentlichungstag der Anmeldung: 15.11.2017
(73) Patentinhaber: Robert Bosch GmbH, 70442 Stuttgart (DE)
(72) Erfinder: LISKOW, Uwe, 71679 Asperg (DE)
(86) Internationale Anmeldenummer: PCT/EP2016/050005
(87) Internationale Veröffentlichungsnummer: WO 2016/110458

(56) Entgegenhaltungen:
- JP-A- 2003 080 537
- US-A1- 2010 065 983
- US-A1- 2011 198 115
- US-A1- 2012 093 954
- US-A1- 2012 319 245

## Beschreibung

### Gebiet der Erfindung

Die Erfindung betrifft ein Verfahren zum Herstellen eines Elektronikmoduls sowie ein Elektronikmodul mit einem Leiterplattenplattenelement und durch eine Schutzmasse geschützten elektronischen Bauelementen, wie es insbesondere für ein Kfz-Getriebesteuergerät eingesetzt werden kann.

### Hintergrund der Erfindung

Elektronikmodule dienen im Allgemeinen dazu, elektrische Schaltkreise auszubilden. Die elektrischen Schaltkreise können beispielsweise Teil eines Steuergeräts sein. Insbesondere im Fahrzeugbau werden Elektronikmodule dazu eingesetzt, Fahrzeugsteuergeräte wie beispielsweise Getriebesteuergeräte bereitzustellen. In einem Elektronikmodul sind dabei typischerweise an einem Leiterplattenelement eine Vielzahl von elektronischen Bauelementen bzw. Bauteilen, wie etwa Sensoren, Steckverbinderelemente, Kondensatoren und/oder andere Bauelemente, vorgesehen, welche mithilfe von Leiterbahnen geeignet miteinander elektrisch verbunden sind.

Insbesondere bei in einem Getriebe eines Kraftfahrzeugs eingesetzten Elektronikmodulen, sogenannten Getriebesteuermodulen, kann es erforderlich sein, die elektronischen Bauelemente des Elektronikmoduls vor den zum Teil aggressiven Medien, wie etwa einem Getriebefluid, umfassend und dauerhaft zu schützen. Dazu werden die elektronischen Bauelemente häufig in einer Schutzmasse vergossen bzw. mit einem Schutzlack überzogen.

Aus der DE 10 2011 088 969 A1 ist ein Getriebesteuermodul bekannt, bei welchem ein Trägersubstrat einer elektronischen Getriebesteuerschaltung und Leitungsbahnabschnitte durch eine Moldmasse gegen Getriebfluid geschützt sind und aus der US 2010/065983 A1 ist ein in Kunstharz eingegossenes Elektronikmodul bekannt.

### Offenbarung der Erfindung

Ausführungsformen der vorliegenden Erfindung können in vorteilhafter Weise ermöglichen, ein robustes, zuverlässiges und kostengünstiges Elektronikmodul, insbesondere ein Getriebesteuermodul, bereitzustellen.

Gemäß der Erfindung wird ein Verfahren zum Herstellen eines Elektronikmoduls nach Anspruch 1 vorgeschlagen. Das erfindungsgemäße Verfahren weist zumindest die folgende Schritte auf: Bereitstellen eines Leiterplattenelements, wobei auf einer Außenfläche des Leiterplattenelements elektronische Bauelemente angeordnet sind und von der Außenfläche abragen, und vollständiges Bedecken der elektronischen Bauelemente mit einer Schutzmasse. Das erfindungsgemäße Verfahren zeichnet sich insbesondere dadurch aus, dass der Schritt des Bedeckens die folgenden Teilschritte aufweist: Bereitstellen eines Formwerkzeugs mit in das Formwerkzeug eingebrachten Vertiefungen, wobei die Vertiefungen derart ausgestaltet sind, dass sie eine geometrische Form bzw. geometrische Struktur der elektronischen Bauelemente nachbilden; zumindest teilweises Befüllen der Vertiefungen mit der Schutzmasse; Zusammenfügen des Leiterplattenelements und des Formwerkzeugs derart, dass die elektronischen Bauelemente vollständig in den mit Schutzmasse befüllten Vertiefungen aufgenommen sind, wobei das Formwerkzeug während des Zusammenfügens derart angeordnet ist, dass die Schutzmasse durch das Erdschwerefeld in den Vertiefungen gehalten ist. Das Verfahren kann weiter ein zumindest teilweises Aushärten und/oder Vernetzen der Schutzmasse sowie ein Entformen des Elektronikmoduls aufweisen.
Die elektronischen Bauelemente können etwa sogenannte Surface Mounted Devices bzw. SMD-Bauelemente, wie etwa Sensoren, Kondensatoren, Steckverbinderelemente, Kontaktelemente und/oder andere Bauelemente umfassen. Auch können die Bauelemente ungehäuste Halbleiterbauelemente umfassen, welche beispielsweise mit Bonddrähten bzw. Wire-Bonds elektrisch kontaktiert sein können, wobei die Bonddrähte hier und im Folgeneden ebenfalls als elektronische Bauelemente erachtet werden können.

Das Leiterplattenelement kann etwa eine flexible Leiterplatte, ein Printed-Circuit-Board (PCB) und/oder eine High-Density-Interconnect (HDI) Leiterplatte bezeichnen. Das Leiterplattenelement kann ferner einstückig oder mehrteilig ausgeführt sein.

Die Vertiefungen können dazu ausgestaltet sein, jeweils wenigstens eines der Bauelemente während der Fertigung des Elektronikmoduls aufzunehmen. Die Vertiefungen können dabei in das Formwerkzeug eingebrachte Aussparungen unterschiedlicher Tiefe bezeichnen. Die Vertiefungen können etwa durch eine Barriere voneinander getrennt sein. Auch können die Vertiefungen Bereiche unterschiedlicher Tiefe einer in das Formwerkzeug eingebrachten Ausnehmung bezeichnen, wobei eine Gesamtheit der Vertiefungen die Ausnehmung bilden kann. Mit anderen Worten kann das Formwerkzeug eine Ausnehmung aufweisen, welche wenigstens einen ersten Bereich und einen zweiten Bereich aufweisen kann, wobei sich der erste und zweite Bereich bezüglich einer Tiefe unterscheiden können. Der erste Bereich und der zweite Bereich können derart ausgestaltet und bemessen sein, dass jeweils wenigsten eines der elektronischen Bauelemente darin aufnehmbar sein kann.

Der Wortlaut, dass "die Vertiefungen des Formwerkzeugs die geometrische Form der Bauelemente nachbilden" kann hier und im Folgenden bedeuten, dass die Vertiefungen wenigstens derart bemessen sind, dass die Bauelemente während der Fertigung des Elektronikmoduls vollständig in der jeweiligen Vertiefung aufnehmbar sind. Vorzugsweise sind die Bauelemente berührungslos in den Vertiefungen aufnehmbar, d.h. eine Oberfläche eines in einer Vertiefung aufgenommenen Bauelements soll während der Fertigung, insbesondere während des Zusammenfügens des Leiterplattenelements und des Formwerkzeugs, nicht in Berührkontakt mit einer Oberfläche der Vertiefung stehen, so dass zwischen den beiden Oberflächen ein Raum für die Schutzmasse bereitgestellt sein kann. Ein Abstand der Oberflächen und/oder der Raum zwischen den beiden Oberflächen soll dabei nicht zu groß sein, um eine unnötig große Schichtdicke der Schutzmasse auf dem jeweiligen Bauelement zu vermeiden. Ein Abstand der Oberflächen kann etwa zwischen 50 µm und 10 mm, beispielsweise zwischen 100 µm und 5 mm, und vorzugsweise zwischen 300 µm und 2 mm sein. Dies kann wiederum bedeuten, dass die Vertiefungen eine Tiefe aufweisen, welche größer sein kann als ein größter Abstand des jeweiligen Bauelements zu der Außenfläche des Leiterplattenelements. Im Falle von soliden SMD-Bauelementen, wie etwa Kondensatoren, kann dies bedeuten, dass die entsprechende Vertiefung wenigstens eine Tiefe aufweisen kann, welche größer als ein Abstand einer Außenkante des Bauelements zur Außenfläche des Leiterplattenelements sein kann. Dagegen kann eine Vertiefung, in welcher beispielsweise ein Bonddraht während der Fertigung aufgenommen sein kann, wenigstens eine Tiefe aufweisen kann, welche größer als ein größter Abstand des Bonddrahtes zur Außenfläche sein kann. Auch kann ein Umfang und/oder ein Querschnitt jeder Vertiefungen wenigstens derart bemessen sein, dass das jeweilige Bauelement während der Fertigung des Elektronikmoduls vollständig und berührungslos darin aufgenommen sein kann. Eine geometrische Form des Querschnitts jeder Vertiefung kann dagegen beliebig ausgestaltet sein, d.h. der Querschnitt der Vertiefungen muss nicht zwingend die gleiche Form aufweisen wie ein Querschnitt des jeweiligen Bauelements. Mit anderen Worten sind die Vertiefungen analog und/oder entsprechend den Dimensionen und/oder Abmessungen der Bauelemente ausgestaltet.

Durch ein derartiges Ausbilden und Dimensionieren der Vertiefungen kann sichergestellt sein, dass die Bauelemente jeweils mit einer für das jeweilige Bauelement optimalen Schutzschicht von Schutzmasse bedeckt sind, etwa zum Schutz gegen mechanische Beschädigungen und/oder zum Schutz gegen Medien wie Getriebefluid und/oder Feuchtigkeit. Eine Mindestschichtdicke der Schutzmasse kann bei rund 300 µm liegen. Ferner kann sichergestellt sein, dass Bauelemente nicht von einer zu dicken bzw. unnötig dicken Schutzschicht bedeckt sind. Eine Maximalschichtdicke kann dabei bei rund 5 mm liegen.

Insgesamt kann durch das erfindungsgemäße Verfahren ein Materialaufwand hinsichtlich der Schutzmasse reduziert sein. Auch kann eine Fertigungszeit, etwa aufgrund verringerter Aushärtezeit für die Schutzmasse, und/oder ein Energieaufwand durch einen im Wesentlichen gleichmäßigen Auftrag bzw. eine im Wesentlichen gleichmäßige Schichtdicke der Schutzmasse auf den Bauelementen reduziert sein. Insgesamt kann so ein vereinfachter Fertigungsablauf und ein kostengünstiges Elektronikmodul bereitgestellt sein. Auch können thermomechanische Spannungen durch unterschiedlich große und/oder zu große Schichtdicken der Schutzmasse reduziert sein.

Ideen zu Ausführungsformen der vorliegenden Erfindung können unter anderem als auf den nachfolgend beschriebenen Gedanken und Erkenntnissen beruhend angesehen werden.

Elektronische Bauelemente eines Elektronikmoduls, wie etwa SMD-Bauelemente, welche auf einem Leiterplattenelement, etwa einem Printed Circuit Board (PCB), angeordnet sind, werden häufig mit einem Lack bzw. einer Schutzmasse bzw. einer Vergussmasse bzw. einem polymeren Schutzsystem geschützt. Dabei können insbesondere Kanten der elektronischen Bauelemente bisweilen unzureichend benetzt sein, da etwa aufgrund einer Oberflächenspannung der Schutzmasse sowie einer in nicht ausgehärtetem Zustand hohen Fließfähigkeit bzw. niedrigen Viskosität der Schutzmasse die Schutzmasse von den Kanten abfließen kann. Dieser Effekt wird häufig als Kantenflucht bezeichnet. Neben SMD-Bauelementen können auch Bare-Dies auf dem Leiterplattenelement und/oder auf einem separaten Trägersubstrat angeordnet und mit einem Lack bzw. einer Schutzmasse geschützt werden. Um beispielsweise die Bonddrähte zum Kontaktieren der Bare-Dies sicher gegen mechanische Beschädigung und/oder gegen Eindringen von Medien, wie etwa Getriebefluid und/oder Feuchtigkeit, umfassend zu schützen, kann ein verhältnismäßig dicker Lackauftrag bzw. eine verhältnismäßig große Schichtdicke der Schutzmasse nötig sein. Deshalb werden derartige Schutzmassen häufig in eine quaderförmige Form gegossen, die bis zur ausreichenden Aushärtung der Schutzmasse auf das Leiterplattenelement gelegt wird, so dass die Schutzmasse nicht von den Bauelemente abfließen kann.

Ein alternativer Ansatz kann durch das sogenannte "Dam & Fill Verfahren" bereitgestellt sein, bei welchem zwei unterschiedlich viskose Schutzmassen und/oder Werkstoffe verarbeitet werden. Dabei kann eine verhältnismäßig feste Verguss-Raupe als äußere Begrenzung eines mit Schutzmasse zu vergießenden Bereichs des Leiterplattenelements ausgebildet werden, und der eigentlich zu vergießende Bereich kann mit einer niederviskosen Schutzmasse aufgefüllt werden. In beiden Fällen wird viel Lack bzw. Schutzmasse benötigt, da etwa Bauelemente niedriger Bauhöhe von einer dicken Schicht Schutzmasse bedeckt sein können. Derartige Verfahren können daher mit verhältnismäßig hohen Materialkosten für die Schutzmasse verbunden sein.

Durch das erfindungsgemäße Verfahren können unnötig dicke Schichtdicken der Schutzmasse vermieden werden, wobei gleichzeitig eine Mindestabdeckung je Bauteil gewährleistet sein kann, wie obenstehend und untenstehend im Detail erläutert. Zusammengefasst und vereinfacht ausgedrückt kann dies beispielsweise dadurch erreicht werden, dass eine Schutzmasse nicht von oben auf eine Leiterplatte samt Bauelemente aufgebracht wird, sondern die flüssige Schutzmasse in Vertiefungen in einem Formwerkzeug eingefüllt wird und dann die Leiterplatte "auf dem Kopf stehend", d.h. mit nach unten abragenden Bauelementen, auf das Formwerkzeug gepresst wird, sodass die Bauelemente in die Schutzmasse eintauchen. Die Kontur der Vertiefungen kann dabei der Kontur der darin aufzunehmenden Bauelemente in etwa komplementär angepasst sein, sodass jedes der Bauelemente zwar vollflächig von Schutzmasse bedeckt ist, eine Schichtdicke der Schutzmasse jedoch einigermaßen homogen und damit ein Materialverbrauch an Schutzmasse gering gehalten werden kann.

Gemäß einer Ausführungsform der Erfindung entspricht eine Kontur und/oder ein Querschnittsprofil der in das Formwerkzeug eingebrachten Vertiefungen einer Topografie und/oder Außenkontur der elektronischen Bauelemente. Mit anderen Worten sind die Vertiefungen derart ausgestaltet, dass ein Profil und/oder Querschnittsprofil der Vertiefungen einem Profil und/oder Querschnittsprofil der Bauelemente entspricht. Demzufolge kann nach dem Aushärten der Schutzmasse eine Oberfläche der Schutzmasse entsprechend den Vertiefungen des Formwerkzeugs und/oder entsprechend einer Bauteilhöhe der jeweiligen Bauelemente eine unebene Oberfläche aufweisen. Durch eine derartige topografische Formgebung der Schutzmasse können etwa unnötig dicke Schichtdicken der Schutzmasse, beispielsweise auf Bauelementen geringer Bauhöhe, vermieden werden, was wiederum zu Materialersparnis hinsichtlich der Schutzmasse sowie zu Kostenreduktion des Elektronikmoduls führen kann. Ferner kann durch eine seitliche Begrenzung der Schutzmasse, welche mithilfe des Formwerkzeugs ausgebildet werden kann, eine Beeinflussung benachbarter Teile und/oder Komponenten des Elektronikmoduls, wie beispielsweise Sensoren und/oder Anschraubflächen, vermieden werden.

Gemäß einer Ausführungsform der Erfindung umfasst der Schritt des Zusammenfügens ein Anordnen und/oder Ausrichten des Elektronikmoduls, so dass ein Normalenvektor der mit den elektronischen Bauelementen bestückten Außenfläche des Leiterplattenelements mit einer Abweichung von weniger als 30° in Wirkrichtung des Erdschwerefeldes ausgerichtet ist. Mit anderen Worten wird während der Fertigung das Leiterplattenelement derart angeordnet, dass die Bauelemente in Richtung eines Erdbodens gerichtet sind, und das Formwerkzeug wird derart ausgerichtet, dass eine Öffnung der Vertiefungen in Gegenrichtung weist. Dadurch kann in vorteilhafter Weise ein Abfließen der im ungehärteten Zustand niedrigviskosen Schutzmasse von den Bauelementen verhindert werden, bis die Schutzmasse ausreichen ausgehärt bzw. vernetzt ist.

Gemäß einer Ausführungsform der Erfindung weist das Verfahren weiter einen Schritt von Einlegen und/oder Einbringen einer Folie, beispielsweise einer Formfolie, in die Vertiefungen vor Befüllen der Vertiefungen mit der Schutzmasse auf, wobei eine Oberfläche des Formwerkzeugs in einem Bereich der Vertiefungen vollständig von der Folie bedeckt ist. Durch das Einlegen der Folie in die Vertiefungen kann in vorteilhafter Weise ein Anhaften der Schutzmasse, insbesondere beim Entformen des Formwerkzeugs, vermieden werden. Weiter kann durch Einsatz der Folie, etwa im Rahmen einer Serienproduktion des Elektronikmoduls, eine Verschleppung z.B. von teilvernetzter bzw. zum Teil ausgehärteter Schutzmasse von einem Elektronikmodul auf ein nachfolgend produziertes vermieden werden.

Gemäß einer Ausführungsform der Erfindung ist die Folie zumindest während des Schrittes des Befüllens durch einen Unterdruck an der Oberfläche des Formwerkzeugs gehalten. Dadurch kann erreicht werden, dass die Folie vollflächig an einer Oberfläche der Vertiefungen anliegt, so dass sichergestellt sein kann, dass ausreichend Schutzmasse in den Vertiefungen aufgenommen werden kann.

Gemäß einer Ausführungsform der Erfindung ist die Folie durchlässig für UV-Licht, und/oder die Folie ist aus Polyamid und/oder Polyamidimid gefertigt. Auch das Formwerkzeug kann durchlässig für UV-Licht ausgestaltet sein, so dass etwa eine Zeitdauer des Schrittes des Aushärtens der Schutzmasse verkürzt und somit Produktionskosten gesenkt werden können. Eine Folie aus Polyamid und/oder Polyamidimid kann einen Wärmeausdehnungskoeffizienten (CTE) ähnlich einem Wärmeausdehnungskoeffizienten der Schutzmasse aufweisen, so dass etwa ein Ablösen der Folie von der Schutzmasse durch thermische Expansion vermieden werden und eine Lebensdauer des Elektronikmoduls erhöht sein kann. Der CTE von Polyamidimid kann bei rund 25 ppm/K, der CTE handelsüblicher Schutzmassen kann etwa bei 22 ppm/K und der CTE einer PCB kann beispielsweise bei etwa 20 ppm/K liegen, so dass zumindest ein Großteil des Elektronikmoduls bezüglich der CTEs einzelner Komponenten in vorteilhafter Weise aufeinander abgestimmt sein kann und etwa mechanische Spannungen zwischen einzelnen Komponenten durch thermische Expansion gering gehalten werden können.

Gemäß einer Ausführungsform der Erfindung liegt zumindest während der Schritte des Befüllens und Zusammenfügens ein Randbereich der Folie an einem direkt an die Vertiefungen angrenzenden Bereich des Formwerkzeugs an, so dass nach dem Schritt des Zusammenfügens der Randbereich der Folie an einem direkt an die elektronischen Bauelemente angrenzenden Bereich der Außenfläche des Leiterplattenelements anliegt. Der Randbereich der Folie kann eine Art Kragen bereitstellen, welcher einen verbesserten Schutz des Formwerkzeugs gegenüber Benetzung und/oder Verschmutzung des Formwerkzeugs mit Schutzmasse bereitstellen kann. Dies kann insbesondere eine Serienfertigung vereinfachen und/oder beschleunigen.

Gemäß einer Ausführungsform der Erfindung umfasst die Schutzmasse ein Polyurethanbasiertes, Silikonbasiertes und/oder Epoxidharzbasiertes Material. Beispielsweise kann die Schutzmasse ein mit Füllstoffen, z.B. basierend auf Si-Oxid und/oder Aluminiumhydroxid, gefülltes Epoxidharz umfassen, welches umfassende Beständigkeit gegen z.B. Getriebefluid und/oder andere Medien bereitstellen kann. Polyurethane können dazu eine kostengünstige Alternative bereitstellen.

Gemäß einer Ausführungsform der Erfindung umfasst der Schritt des Aushärtens der Schutzmasse ein Erhitzen und/oder ein Einstrahlen von UV-Licht. Dadurch kann in vorteilhafter Weise eine Aushärtedauer der Schutzmasse reduziert sein bzw. eine schnelle Vorvernetzung der Schutzmasse erreicht werden. Beispielsweise kann in das Formwerkzeug eine Heizvorrichtung integriert sein und/oder an dem Formwerkzeug angeordnet sein. Auch kann etwa ein Heißluftgebläse zum Erhitzen des Formwerkzeugs und/oder des Elektronikmoduls vorgesehen sein. Zum Einstrahlen von UV-Licht auf die Schutzmasse zum Aushärten derselben kann das Formwerkzeug zumindest für UV-Licht durchlässig und/oder transparent ausgebildet sein.

Erfindungsgemäß weist das Leiterplattenelement eine vollständig durch das Leiterplattenelement durchgängig ausgestaltete Öffnung auf, über welche während des Schrittes des Zusammenfügens eine überschüssige Schutzmasse entweichen kann. Die Öffnung kann etwa eine Steigeröffnung bezeichnen. Dadurch kann zum einen sichergestellt sein, dass während des Fertigungsprozesses eine blasen- und/oder lunkerfreie Schutzmasse um die Elektronikbauelemente herum erreicht wird und eine für einen umfassenden Schutz der Bauelemente nötige unmittelbare Benetzung der Bauteile erfolgen kann, insbesondere durch Verdrängen der Luft bis zum Abschließen des WZ an der Leiterplatte und Abführen von Gasblasen, die während des Vernetzungsprozesses aus der Schutzmasse entweichen können. Zum anderen kann durch Entweichen überschüssiger Schutzmasse sichergestellt sein, dass beispielsweise eine Berandung der Schutzmasse auf dem Leiterplattenelement klar definierbar sein kann und nicht etwa die überschüssige Schutzmasse zwischen Formwerkzeug und Leiterplattenelement herausgedrückt werden kann.

Ein weiterer Aspekt der Erfindung betrifft ein Elektronikmodul, insbesondere ein Getriebesteuermodul. Das Elektronikmodul weist ein Leiterplattenelement mit von einer Außenfläche des Leiterplattenelements abragend angeordneten elektronischen Bauelementen auf. Das Elektronikmodul zeichnet sich insbesondere dadurch aus, dass die elektronischen Bauelemente vollständig von einer Schutzmasse bedeckt sind, wobei die Schutzmasse zwischen einer Folie und einer Außenfläche des Leiterplattenelements angeordnet ist.

An die Schutzmasse können insbesondere bei Getriebesteuermodulen hohe Anforderungen gestellt sein. Zum einen sollte die Schutzmasse beständig gegen Getriebefluid und/oder andere Medien sein und zum anderen sollte ein thermischer Ausdehnungskoeffizient der Schutzmasse ähnlich dem der Bauelemente sein. Weiter sollte die Schutzmasse schnell aushärtbar, etwa durch Einsatz von UV-Licht und/oder Wärme, sein. Insbesondere umfassend getriebefluidbeständige Schutzmassen sind oftmals teuer und nicht mit UV-Licht aushärtbar, was den Produktionsprozess des Elektronikmoduls und das Elektronikmodul selbst kostenintensiv machen kann. Verschiedene Schutzmassen, die idelae thermische und/oder thermomechanische Eigenschaften haben können, bieten oftmals nur unzureichenden Schutz gegen Feuchtigkeit und/oder Getriebefluid. Beispielsweise kann Feuchtigkeit durch eine polymere Schutzmasse bis zur Elektronik bzw. den Bauelementen diffundieren und deren Funktionsweise beinträchtigen. Durch Verwenden der Folie kann in vorteilhafter Weise ein umfassender außenflächiger Schutz gegen Getriebefluid und/oder Feuchtigkeit und/oder andere Medien gewährleistet sein, so dass als Schutzmasse, welche zwischen der Außenfläche des Leiterplattenelements und der Folie angeordnet sein kann, eine kostengünstige Variante gewählt werden kann, ohne Einbußen bezüglich eines Schutzes der Bauelemente. Die Folie kann somit als eine Art Kappe und/oder Zusatzschutzschicht für die darunterliegend angeordnete Schutzmasse sowie die Bauelemente erachtet werden. Die Folie kann somit einen zusätzlichen Schutz der Schutzmasse sowie der Bauelemente bereitstellen. Dadurch kann eine Robustheit gegen Getriebefluid und/oder andere Medien sowie eine Robustheit gegen thermomechanische Spannungen erhöht sein, da beispielsweise die unter der Folie angeordnete Schutzmasse auch nach einem Vernetzen elastisch bleiben kann und nicht zwingend vollständig ausgehärtet sein muss.

Gemäß einer Ausführungsform der Erfindung steht die Folie in vollflächigem Kontakt mit der Schutzmasse. Dadurch können Lufteinschlüsse zwischen Folie und Schutzmasse vermieden werden. Ferner kann eine Haftkraft der Folie auf der Schutzmasse durch vollflächigen Kontakt erhöht sein, was wiederum ein Ablösen der Folie vermeiden und eine Lebensdauer des Elektronikmoduls erhöhen kann.

Es wird darauf hingewiesen, dass einige der möglichen Merkmale und Vorteile der Erfindung hierin mit Bezug auf unterschiedliche Ausführungsformen beschrieben sind. Ein Fachmann erkennt, dass die Merkmale in geeigneter Weise kombiniert, angepasst oder ausgetauscht werden können, um zu weiteren Ausführungsformen der Erfindung zu gelangen.

Weiter wird darauf hingewiesen, dass Merkmale und Elemente des erfindungsgemäßen Verfahrens zum Herstellen des Elektronikmoduls, wie obenstehend und untenstehend beschrieben, auch Merkmale und Elemente des erfindungsgemäßen Elektronikmoduls, wie obenstehend und untenstehend beschrieben, und umgekehrt sein können.

### Kurze Beschreibung der Zeichnungen

Nachfolgend werden Ausführungsformen der Erfindung unter Bezugnahme auf die beigefügten Zeichnungen beschrieben, wobei weder die Zeichnungen noch die Beschreibung als die Erfindung einschränkend auszulegen sind.

Fig. 1A veranschaulicht einen Teil der erfindungsgemäßen Prozessierungsschritte.

Fig. 2 und 3A veranschaulichen jeweils Prozessierungsschritte eines erfindungsgemäßen Verfahrens zum Herstellen eines Elektronikmoduls.

Fig. 3B und 4 zeigen jeweils ein erfindungsgemäß hergestelltes Elektronikmodul.

Die Figuren sind lediglich schematisch und nicht maßstabsgetreu. Gleiche Bezugszeichen bezeichnen in den Figuren gleiche oder gleichwirkende Merkmale.

### Ausführungsformen der Erfindung

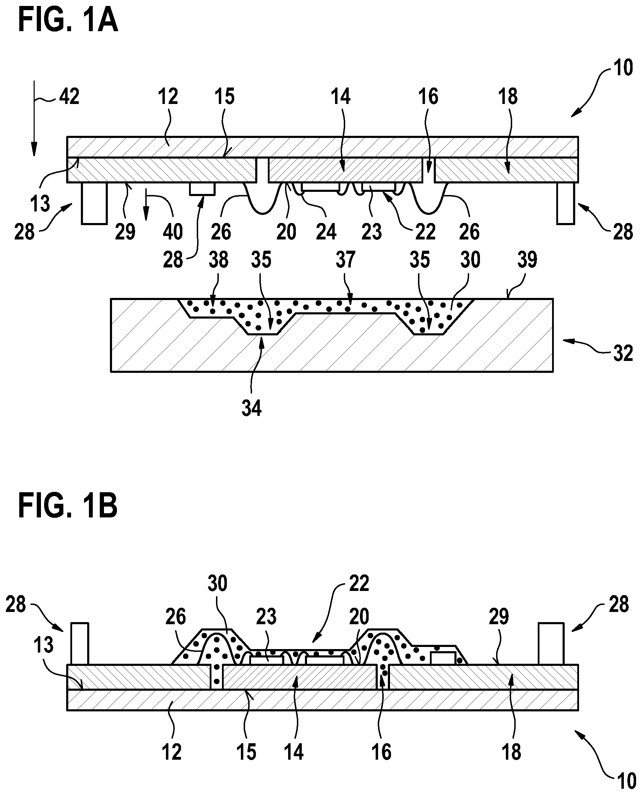

Fig. 1A veranschaulicht Prozessierungsschritte eines Verfahrens zum Herstellen eines Elektronikmoduls 10. Fig. 1B,zeigt ein entsprechend hergestelltes Elektronikmodul 10.

Das Elektronikmodul 10 weist eine Trägerplatte 12 auf, welche eine Metallplatte oder eine Metall-Kunststoffverbundplatte sein kann. Die Trägerplatte 12 kann insbesondere als Kühlkörper des Elektronikmoduls 10 dienen und zum Abführen von Wärme vorgesehen sein.

Auf einer Seite 13 der Trägerplatte 12 ist ein erstes Leiterplattenelement 14 angeordnet. Das Leiterplattenelement 14 kann beispielsweise mit einer Seite 15 mit der Seite 13 der Trägerplatte 12 verklebt, verlötet und/oder verschweißt sein. Das erste Leiterplattenelement 14 ist in einer Aussparung 16 eines zweiten Leiterplattenelements 18 angeordnet, welche das erste Leiterplattenelement 14 ringförmig umschließt. Das erste Leiterplattenelement 14 kann etwa in Form einer LTCC-Substratplatte ("low temperature cofired ceramics", LTCC) gefertigt sein und/oder etwa als HDI-Leiterplatte ("high density interconnect", HDI) ausgestaltet sein. Das zweite Leiterplattenelement 18 kann etwa als reguläre PCB-Leiterplatte oder als Flexfolie ausgestaltet sein.

Auf einer Außenfläche 20 des ersten Leiterplattenelements 14 sind elektronische Bauelemente 22 angeordnet, welche zumindest teilweise von der Außenfläche abragen. Die in Fig. 1A gezeigten Bauelemente 22 umfassen dabei zumindest ein ungehäustes Halbleiterbauelement 23, etwa ein Siliziumbauelement, welches im Bare-Die-Verfahren auf der Außenfläche 20 des ersten Leiterplattenelements 14 montiert ist und mit freiliegenden Bonddrähten 24 kontaktiert ist. Alternativ oder zusätzlich können die elektronischen Bauelemente 22 SMD-Bauelemente umfassen bzw. aufweisen. Die elektronischen Bauelemente 22 stellen eine elektronische Schaltung, beispielsweise für ein Getriebesteuergerät mit integrierter Transmission Control Unit (iTCU) für ein Kraftfahrzeug bereit. Das Elektronikmodul 10 kann ein Getriebesteuermodul sein und das erste Leiterplattenelement 14 kann als Schaltungsträger für das Getriebesteuermodul erachtet werden.

Das erste Leiterplattenelement 14 ist mit freiliegenden Bonddrähten 26 mit dem umliegend um das erste Leiterplattenelement 14 angeordneten zweiten Leiterplattenelement 18 kontaktiert. Alternativ oder zusätzlich zu den Bonddrähten 26 können auch Lötstellen zur elektronischen Kontaktierung oder andere geeignete Kontaktierungselemente vorgesehen sein. Die Leiterplattenelemente 14 und 18 können auch als ein durchgehendes bzw. einstückiges Leiterplattenelement ausgeführt sein, so dass die Verbindungselemente wie Bonddrähte 28 entfallen können.

Weiter weist das Elektronikmodul 10 SMD-Bauelemente 28 auf, welche auf einer Seite 29 des zweiten Leiterplattenelements 18 angeordnet sind und von dieser abragen. Die SMD-Bauelemente 28 können etwa Sensoren, Kondensatoren, Steckverbinderelemente oder andere Komponenten aufweisen.

Die elektronischen Bauelemente 22 sowie die Bonddrähte 26 sind mit einer Schutzmasse 30 gegen mechanische Beschädigung und/oder gegen Medien, wie etwa Getriebefluid und/oder Feuchtigkeit, geschützt, welche, wie im Folgenden beschrieben, gemäß dem Herstellungsverfahren auf den Bauelementen 22 und den Bonddrähten 26 angebracht werden kann.

Nach Bereitstellen der Trägerplatte 12 mit erstem und zweitem Leiterplattenelement 14, 18 sowie den auf dem ersten Leiterplattenelement 14 angeordneten, montierten und mit Bonddrähten 26 kontaktierten elektronischen Bauelementen 22 werden die elektronischen Bauelemente 22 sowie die Bonddrähte 26 mit Schutzmasse 30 vollständig bedeckt und dadurch geschützt. Auch auf dem zweiten Leiterplattenelement 18 angeordnete Bauelemente 28 können mit Schutzmasse 30 vollständig bedeckt werden. Die Schutzmasse 30 kann etwa Polyurethan, ein Silikon und/oder Epoxidharz umfassen. Auch kann die Schutzmasse 30 einen Lack umfassen.

Zum Anbringen der Schutzmasse 30 wird zunächst ein Formwerkzeug 32 bereitgestellt, in welches eine Ausnehmung 34 mit Bereichen unterschiedlicher Tiefe bzw. Vertiefungen 35, 37, 38 eingebracht sind. Dabei soll jeweils wenigstens eines der Bauelemente 22 und/oder ein Bonddraht 26 während der Fertigung des Elektronikmoduls 10 in einer der Vertiefungen 35, 37, 38 aufgenommen sein. Die Vertiefungen 35, 37, 38 sind dabei wenigstens derart bemessen, dass die Bauelemente 22, 28 bzw. Bonddrähte 26 vollständig und berührungslos darin aufnehmbar sind. Bei dem in Fig. 1A gezeigten Beispiel umfasst die Ausnehmung 34 zwei Vertiefungen 35 bzw. zwei Bereiche zur Aufnahme jeweils eines der Bonddrähte 26 sowie eine weitere Vertiefung 37 bzw. einen weiteren Bereich zur Aufnahme der auf dem ersten Leiterplattenelement 14 angeordneten weiteren Bauelemente 22. Die Vertiefung 37 ist dabei zwischen den beiden Vertiefungen 35 angeordnet und weist aufgrund einer geringeren Bauteilhöhe der in der Vertiefung 37 aufzunehmenden Bauelemente 22 im Vergleich zu einem Maximalabstand der Bonddrähte 26 von der Außenfläche 20 eine geringere Tiefe als die Vertiefungen 35 auf. Ferner ist eine weitere Vertiefung 38 in das Formwerkzeug 32 zur Aufnahme eines auf dem zweiten Leiterplattenelement 18 angeordneten Bauelements 28 eingebracht. Die Gesamtheit der Vertiefungen 35, 37, 38 können somit die Ausnehmung 34 bilden, wobei die einzelnen Vertiefungen 35, 37, 38 nahtlos ineinander übergehen können oder etwa durch Barrieren voneinander getrennt sein können. Die Vertiefungen 35, 37, 38 und/oder die Ausnehmung 34 können etwa durch Fräsen in das Formwerkzeug 32 eingebracht sein.

Die Vertiefungen 35, 37, 38 weisen jeweils eine Tiefe auf, welche größer ist als ein größter Abstand des jeweiligen Bauelements 22, 28, 26 zu der Außenfläche 20 wenigstens eines der Leiterplattenelemente 14, 18. Ein Umfang und/oder ein Querschnitt jeder Vertiefung 35, 37, 38 ist wenigstens derart bemessen, dass das jeweilige Bauelement 22, 26, 28 während der Fertigung des Elektronikmoduls 10 vollständig und berührungslos darin aufgenommen sein kann. Eine geometrische Form des Querschnitts jeder Vertiefung 35, 37, 38 kann dabei beliebig ausgestaltet sein, d.h. der Querschnitt der Vertiefungen 35, 37, 38 muss nicht zwingend die gleiche Form aufweisen wie ein Querschnitt des jeweiligen Bauelements 22, 26, 28. Mit anderen Worten sind die Vertiefungen 35, 37, 38 analog und/oder entsprechend den Dimensionen und/oder Abmessungen der Bauelemente 22, 26, 28 ausgestaltet. Ein Querschnittsprofil und/oder eine Kontur der in das Formwerkzeug eingebrachten Ausnehmung 34 kann einem Querschnittsprofil der Bauelemente 22, 28 entsprechen.

Das Formwerkzeug 32 wird im Erdschwerefeld derart angeordnet bzw. ausgerichtet, dass die Vertiefungen 35, 37, 38 mit Schutzmasse 30 befüllbar sind und diese darin durch Schwerkraft bzw. durch das Erdschwerefeld gehalten ist. Das Formwerkzeug 32 wird dann mit flüssiger, noch nicht vernetzter Schutzmasse 30 befüllt, wobei vorzugsweise ein Volumen der Schutzmasse 30 gleich dem Volumen der Ausnehmung 34 abzüglich der Volumina der darin aufzunehmenden Bauelemente 22, 26, 28 ist.

Das Elektronikmodul 10 wird derart ausgerichtet bzw. angeordnet, dass ein Normalenvektor 40 der Außenfläche 20 höchstens mit einer Abweichung von rund 30° in einer Wirkrichtung 42 des Erdschwerefelds ausgerichtet ist. Mit anderen Worten wird das Elektronikmodul 10 umgedreht bzw. kopfüber angeordnet.

Das Elektronikmodul 10 und das Formwerkzeug 32 werden anschließend zusammengefügt, so dass eine Außenfläche 39 des Formwerkzeugs 32 bündig an dem ersten und/oder zweiten Leitplattenelement 14, 18 anliegt. Beim Zusammenfügen wird wenigstens eines des Elektronikmoduls 10 und des Formwerkzeugs 32 auf das jeweils andere Bauteil zubewegt, wobei die Bauelemente 22, 26, 28 in die mit Schutzmasse 30 befüllten Vertiefungen 35, 37, 38 eintauchen. Das Formwerkzeug 32 wird zumindest so lange gehalten, bis eine erste Vernetzung der Schutzmasse 30 erfolgt ist. Ein Vernetzen bzw. Aushärteprozess kann dabei durch Erhitzen und/oder Einstrahlen von UV-Licht beschleunigt werden. Auch kann eine Vernetzung der Schutzmasse 30 ein Einstrahlen einer gewissen Lichtenergie und/oder ein Zuführen einer gewissen Wärmeenergie erfordern. Beispielsweise kann eine Heizvorrichtung in das Formwerkzeug 32 eingebracht sein und/oder das Formwerkzeug 32 kann für UV-Licht durchlässig ausgestaltet sein und z.B. von einer dem Elektronikmodul 10 gegenüberliegenden Seite mit UV-Licht bestrahlt werden.

Nach einer ersten Vernetzung bzw. Teilaushärtung der Schutzmasse 30 hat die Schutzmasse 30 ausreichend Formstabilität, und das Elektronikmodul 10 sowie das Formwerkzeug 32 können entformt werden. Die Schutzmasse 30 kann dann z. B. in einer Wärmekammer vollständig ausgehärtet werden

Der gesamte oder ein Teil des obenstehend beschriebenen Verfahrens kann zur Vermeidung von Gaseinschlüssen in der Schutzmasse 30 in einer Vakuumkammer erfolgen. Auch kann die Schutzmasse 30 mit Druck beaufschlagt werden, beispielsweise mit 1 bis 2 bar, um den Benetzungsvorgang zu verbessern.

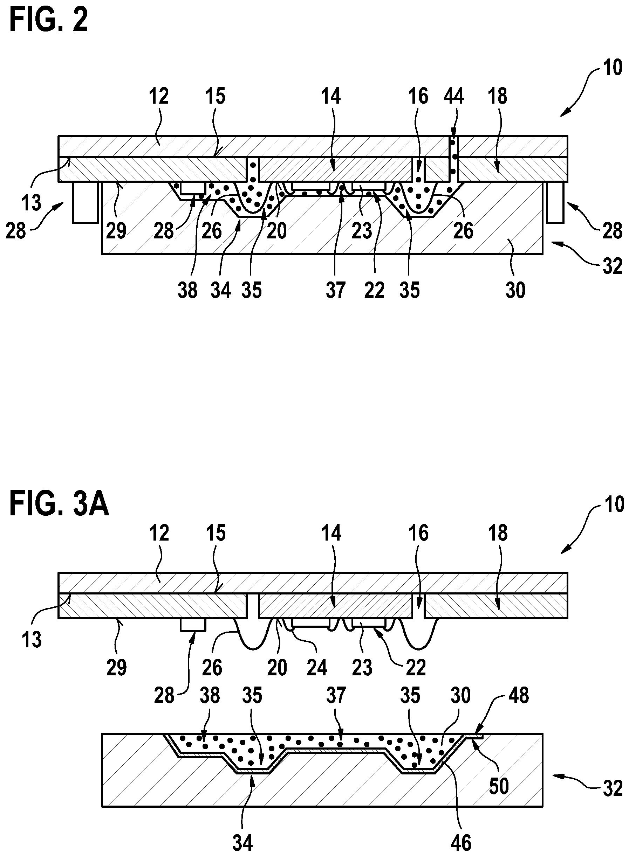

Fig. 2 veranschaulicht Prozessierungsschritte eines erfindungsgemäßen Verfahrens zum Herstellen eines Elektronikmoduls 10. Sofern nicht anders beschrieben kann das in Fig. 2 illustrierte Verfahren die gleichen Schritte wie das in Fig. 1A illustrierte Verfahren aufweisen.

Das in Fig. 2 gezeigte Elektronikmodul 10 weist erfindungsgemäß eine vollständig durch das zweite Leiterplattenelement 18 und die Trägerplatte 12 durchgängig ausgebildete Öffnung 44 auf, welche etwa als Steigeröffnung bezeichnet werden kann und über welche während des Schrittes des Zusammenfügens des Elektronikmoduls 10 und des Formwerkzeugs 32 überschüssige Schutzmasse 30 entweichen und/oder aus dem Elektronikmodul 10 austreten kann.

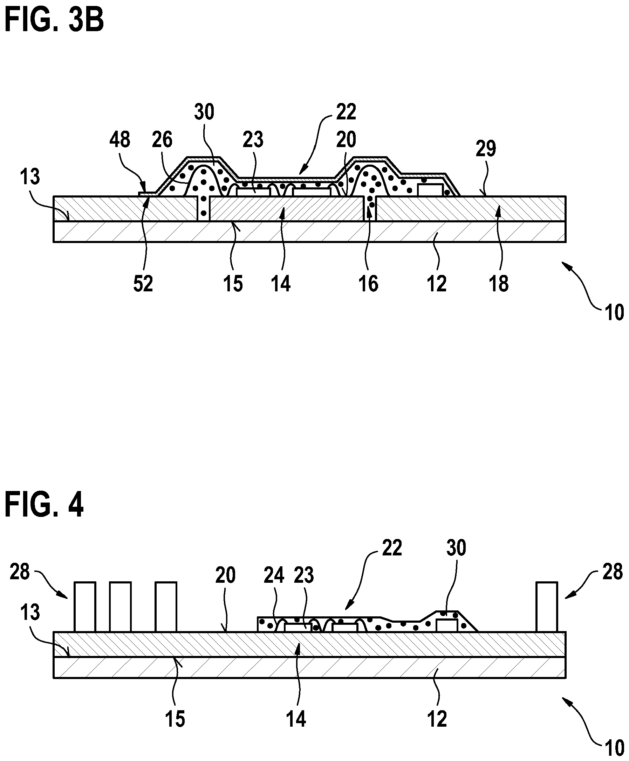

Fig. 3A veranschaulicht Prozessierungsschritte eines erfindungsgemäßen Verfahrens zum Herstellen eines Elektronikmoduls 10. Fig. 3B zeigt ein erfindungsgemäß hergestelltes Elektronikmodul 10. Sofern nicht anders beschrieben kann das in Fig. 3A illustrierte Verfahren die gleichen Schritte wie die in Fig. 1A und 2 illustrierten Verfahren aufweisen. Auch kann das in Fig. 3B gezeigte Elektronikmodul 10 sämtliche Merkmale und Elemente des in Fig. 1B gezeigten Elektronikmoduls 10 aufweisen.

Wie in Fig. 3A illustriert, kann vor Befüllen der Vertiefungen 35, 37, 38 bzw. der Ausnehmung 34 mit Schutzmasse 30 eine Folie 46 in die Ausnehmung 34 bzw. die Vertiefungen 35, 37, 38 eingelegt werden, so dass eine Oberfläche des Formwerkzeugs 32 im Bereich der Vertiefungen 35, 37, 38 vollständig von der Folie 46 bedeckt ist. Die Folie 46 kann etwa eine Formfolie sein, welche ferner für UV-Licht durchlässig ausgestaltet sein kann. Weiter kann die Folie 46 etwa aus Polyamid und/oder Polyamidimid gefertigt sein.

Die Folie 46 kann zumindest während des Befüllens der Ausnehmung 34 mit Schutzmasse 30 durch einen Unterdruck in den Vertiefungen 35, 37, 38 bzw. in der Ausnehmung 34 gehalten sein, so dass sie vollflächig und bündig an dem Formwerkzeug 32 anliegen kann.

Ein Randbereich 48 der Folie 46 liegt zumindest während des Schrittes des Befüllens der Ausnehmung 34 mit Schutzmasse 30 an einem direkt an die Ausnehmung 34 bzw. an die Vertiefungen 35, 37, 38 angrenzenden Bereich 50 des Formwerkzeugs 32 an, so dass nach dem Vernetzen und/oder Aushärten der Schutzmasse 30 der Randbereich 48 der Folie 46 direkt an einem Bereich 52 der Außenfläche 20 des zweiten Leiterplattenelements 18 anliegt.

Bei dem derart hergestellten Elektronikmodul 10 ist die Schutzmasse 30 zwischen der Folie 46 und einer Außenfläche 20 des ersten und/oder zweiten Leiterplattenelements 14, 18 aufgenommen und/oder angeordnet. Die Folie 46 kann dabei im Wesentlichen, etwa abgesehen von dem Randbereich 48, in vollflächigem Kontakt mit der Schutzmasse 30 stehen.

Die Folie 46 kann das Entformen erleichtern und eine Sauberkeit des Formwerkzeugs 32 sicherstellen, d.h. eine Benetzung des Formwerkzeugs 32 mit Schutzmasse 30 und/oder ein Anhaften der Schutzmasse 30 am Formwerkzeug 32 kann vermieden werden. Bei nur geringer Vorvernetzung der Schutzmasse 30 kann die Folie 46 ferner eine gewisse Formstabilität der Schutzmasse 30 bis zum endgültigen Vernetzen bzw. Aushärten derselben gewährleisten.

Fig. 4 zeigt ein erfindungsgemäß hergestelltes Elektronikmodul 10. Sofern nicht anders beschreiben kann das Elektronikmodul 10 der Fig. 4 dieselben Merkmale und Eigenschaften wie die Elektronikmodule der Fig. 1B und 3B aufweisen.

Im Gegensatz zu den in Fig. 1A bis 3B gezeigten Elektronikmodulen weist das Elektronikmodul 10 der Fig. 4 ein einstückiges Leiterplattenelement 14 auf, welches auf der Trägerplatte 12 angeordnet ist.

Abschließend ist darauf hinzuweisen, dass Begriffe wie "aufweisend", "umfassend", etc. keine anderen Elemente oder Schritte ausschließen und Begriffe wie "eine" oder "ein" keine Vielzahl ausschließen. Ferner sei darauf hingewiesen, dass Merkmale oder Schritte, die mit Verweis auf eines der obigen Ausführungsbeispiele beschrieben worden sind, auch in Kombination mit anderen Merkmalen oder Schritten anderer oben beschriebener Ausführungsbeispiele verwendet werden können. Bezugszeichen in den Ansprüchen sind nicht als Einschränkung anzusehen.

## Patentansprüche

1. Verfahren zum Herstellen eines Elektronikmoduls (10), insbesondere eines Getriebesteuermoduls, das Verfahren aufweisend die Schritte:
Bereitstellen eines Trägersubstrats,
wobei auf einer Außenfläche (20) des Trägersubstrats elektronische Bauelemente (22) angeordnet sind und von der Außenfläche (20) abragen; und
vollständiges Bedecken der elektronischen Bauelemente (22) mit einer Schutzmasse (30), wobei der Schritt des Bedeckens die folgenden Teilschritte aufweist:
Bereitstellen eines Formwerkzeugs (32) mit in das Formwerkzeug (32) eingebrachten Vertiefungen (35, 37, 38), wobei die Vertiefungen (35, 37, 38) derart ausgestaltet sind, dass sie eine geometrische Form der elektronischen Bauelemente (22) nachbilden;
zumindest teilweises Befüllen der Vertiefungen (35, 37, 38) mit der Schutzmasse (30); und
Zusammenfügen des Trägersubstrats und des Formwerkzeugs (32) derart, dass die elektronischen Bauelemente (22) vollständig in den mit Schutzmasse (30) befüllten Vertiefungen (35, 37, 38) aufgenommen sind;
wobei das Formwerkzeug (32) während des Zusammenfügens derart angeordnet ist, dass die Schutzmasse (30) durch das Erdschwerefeld in den Vertiefungen (35, 37, 38) gehalten ist, **dadurch gekennzeichnet, dass** das Trägersubstrat eine Trägerplatte (12) und ein Leiterplattenelement (14, 18) umfasst;
wobei die Trägerplatte (12) und das Leiterplattenelement (14, 18) eine vollständig durch die Trägerplatte (12) und das Leiterplattenelement (14, 18) durchgängig ausgestaltete Öffnung (44) aufweisen, über welche während des Schrittes des Zusammenfügens eine überschüssige Schutzmasse (30) entweichen und aus dem Elektronikmodul austreten kann.

2. Verfahren gemäß Anspruch 1,
wobei eine Kontur der in das Formwerkzeug (32) eingebrachten Vertiefungen (35, 37, 38) einer Topografie der elektronischen Bauelemente (22) entspricht.

3. Verfahren gemäß einem der Ansprüche 1 oder 2,
wobei der Schritt des Zusammenfügens ein Anordnen des Elektronikmoduls (10) umfasst, so dass ein Normalenvektor (40) der mit den elektronischen Bauelementen (22) bestückten Außenfläche (20) des Leiterplattenelements (14, 18) mit einer Abweichung von weniger als 30° in Wirkrichtung (42) des Erdschwerefeldes ausgerichtet ist.

4. Verfahren gemäß einem der voranstehenden Ansprüche, weiter aufweisend:
Einbringen einer Folie (46) in die Vertiefungen (35, 37, 38) vor Befüllen der Vertiefungen (35, 37, 38) mit der Schutzmasse (30),
wobei eine Oberfläche des Formwerkzeugs (32) in einem Bereich der Vertiefungen (35, 37, 38) vollständig von der Folie (46) bedeckt ist.

5. Verfahren gemäß Anspruch 4,
wobei die Folie (46) zumindest während des Schrittes des Befüllens durch einen Unterdruck an der Oberfläche des Formwerkzeugs (32) gehalten ist.

6. Verfahren gemäß einem der Ansprüche 4 oder 5,
wobei die Folie (46) durchlässig für UV-Licht ist; und/oder
wobei die Folie (46) aus wenigstens einem von Polyamid und Polyamidimid gefertigt ist.

7. Verfahren gemäß einem der Ansprüche 4 bis 6,
wobei zumindest während der Schritte des Befüllens und Zusammenfügens ein Randbereich (48) der Folie (46) an einem direkt an die Vertiefungen (35, 37, 38) angrenzenden Bereich (50) des Formwerkzeugs (32) anliegt, so dass nach dem Schritt des Zusammenfügens der Randbereich (48) der Folie (46) an einem direkt an die elektronischen Bauelemente (22) angrenzenden Bereich (52) der Außenfläche (20) des Leiterplattenelements (14, 18) anliegt.

8. Verfahren gemäß einem der voranstehenden Ansprüche,
wobei die Schutzmasse (30) ein Polyurethanbasiertes, ein Silikonbasiertes und/oder ein Epoxidharzbasiertes Material umfasst.

9. Verfahren gemäß einem der voranstehenden Ansprüche,
wobei der Schritt des Aushärtens der Schutzmasse (30) ein Erhitzen und/oder ein Einstrahlen von UV-Licht umfasst.

## Claims

1. Method for producing an electronics module (10), in particular a transmission control module, the method comprising the steps of:
providing a carrier substrate,
wherein electronic components (22) are arranged on an outer surface (20) of the carrier substrate and protrude from the outer surface (20); and
completely covering the electronic components (22) with a protective compound (30),
wherein the covering step comprises the following substeps:
providing a mould (32) having depressions (35, 37, 38) made in the mould (32), wherein the depressions (35, 37, 38) are designed in such a way that they replicate a geometrical form of the electronic components (22);
at least partially filling the depressions (35, 37, 38) with the protective compound (30); and
joining the carrier substrate and the mould (32) together in such a way that the electronic components (22) are completely received in the depressions (35, 37, 38) filled with protective compound (30);
wherein, during the joining together, the mould (32) is arranged in such a way that the protective compound (30) is kept in the depressions (35, 37, 38) by gravity,
**characterized in that** the carrier substrate comprises a carrier board (12) and a circuit board element (14, 18);
wherein the carrier board (12) and the circuit board element (14, 18) have an opening (44) that is designed to pass completely through the carrier board (12) and the circuit board element (14, 18),
via which excessive protective compound (30) can escape and leave the electronics module during the joining-together step.

2. Method according to Claim 1,
wherein a contour of the depressions (35, 37, 38) made in the mould (32) corresponds to a topography of the electronic components (22).

3. Method according to either of Claims 1 and 2, wherein the joining-together step comprises arranging the electronics module (10) such that a normal vector (40) of the outer surface (20) of the circuit board element (14, 18) loaded with the electronic components (22) is aligned in the direction of gravitational effect (42) with a deviation of less than 30°.

4. Method according to one of the preceding claims, also comprising:
introducing a film (46) into the depressions (35, 37, 38) before filling the depressions (35, 37, 38) with the protective compound (30),
wherein a surface of the mould (32) in a region of the depressions (35, 37, 38) is completely covered by the film (46).

5. Method according to Claim 4,
wherein the film (46) is held on the surface of the mould (32) by negative pressure at least during the filling step.

6. Method according to either of Claims 4 and 5,
wherein the film (46) is permeable to UV light; and/or
wherein the film (46) is produced from at least one out of polyamide and polyamide-imide.

7. Method according to one of Claims 4 to 6,
wherein, at least during the filling and joining-together steps, a peripheral region (48) of the film (46) lies against a region (50) of the mould (32) that is directly adjacent to the depressions (35, 37, 38), so that, after the joining-together step, the peripheral region (48) of the film (46) lies against a region (52) of the outer surface (20) of the circuit board element (14, 18) that is directly adjacent to the electronic components (22).

8. Method according to one of the preceding claims,
wherein the protective compound (30) comprises a polyurethane-based, silicone-based and/or epoxy-resin-based material.

9. Method according to one of the preceding claims,
wherein the step of curing the protective compound (30) comprises heating and/or irradiating by UV light.

## Revendications

1. Procédé de fabrication d'un module électronique (10), en particulier d'un module de commande de transmission, le procédé comprenant les étapes suivantes :
la fourniture d'un substrat de support,
dans lequel des composants électroniques (22) sont disposés sur une surface extérieure (20) du substrat de support et font saillie par rapport à la surface extérieure (20) ; et
recouvrir entièrement les composants électroniques (22) avec une matière protectrice (30), dans lequel l'étape de recouvrement comprend les sous-étapes suivantes :
la fourniture d'un moule (32) pourvu de cavités (35, 37, 38) ménagées dans le moule (32), dans lequel les cavités (35, 37, 38) sont configurées pour reproduire une forme géométrique des composants électroniques (22) ;
le remplissage au moins partiel des cavités (35, 37, 38) avec la matière protectrice (30) ; et
l'assemblage du substrat de support et du moule (32) de manière à ce que les composants électroniques (22) soient entièrement logés dans les cavités (35, 37, 38) remplies de matière protectrice (30) ;
dans lequel le moule (32) est agencé, pendant l'assemblage, de manière à ce que la matière protectrice (30) soit maintenue dans les cavités (35, 37, 38) par le champ de gravité terrestre,
**caractérisé en ce que** le substrat de support comprend une plaque de support (12) et un élément de circuit imprimé (14, 18) ;
dans lequel la plaque de support (12) et l'élément de circuit imprimé (14, 18) présentent une ouverture (44) entièrement ménagée à travers la plaque de support (12) et l'élément de circuit imprimé (14, 18), par l'intermédiaire de laquelle, lors de l'étape d'assemblage, une matière protectrice (30) en excès peut s'échapper et sortir du module électronique.

2. Procédé selon la revendication 1,
dans lequel un contour des cavités (35, 37, 38) ménagées dans le moule (32) correspond à une topographie des composants électroniques (22).

3. Procédé selon l'une des revendications 1 ou 2,
dans lequel l'étape d'assemblage comprend un agencement du module électronique (10) de telle sorte qu'un vecteur normal (40) à la surface extérieure (20) de l'élément de circuit imprimé (14, 18) pourvu des composants électroniques (22) soit orienté avec un écart inférieur à 30° dans la direction d'action (42) du champ de gravitation terrestre.

4. Procédé selon l'une des revendications précédentes, comportant en outre :
l'insertion d'un film (46) dans les cavités (35, 37, 38) avant le remplissage des cavités (35, 37, 38) avec la matière protectrice (30),
dans lequel une surface du moule (32) dans une région des cavités (35, 37, 38) est entièrement recouverte par le film (46).

5. Procédé selon la revendication 4,
dans lequel le film (46) est maintenu au moins pendant l'étape de remplissage par une dépression au niveau de la surface du moule (32).

6. Procédé selon l'une des revendications 4 ou 5,
dans lequel le film (46) est transparent à la lumière UV ; et/ou
dans lequel le film (46) est constitué d'au moins l'un d'un polyamide et d'un polyamideimide.

7. Procédé selon l'une des revendications 4 à 6,
dans lequel, au moins lors des étapes de remplissage et d'assemblage, une région de bord (48) du film (46) repose sur une région (50) du moule (32) qui est directement adjacente aux cavités (35, 37, 38), de manière à ce qu'après l'étape d'assemblage, la région de bord (48) du film (46) repose sur une région (52) de la surface extérieure (20) de l'élément de circuit imprimé (14, 18) qui est directement adjacente aux composants électroniques (22).

8. Procédé selon l'une des revendications précédentes,
dans lequel la matière protectrice (30) comprend un matériau à base de polyuréthane, un matériau à base de silicone et/ou un matériau à base de résine époxy.

9. Procédé selon l'une des revendications précédentes,
dans lequel l'étape de durcissement de la matière protectrice (30) comprend le chauffage et/ou l'exposition à de la lumière UV.
